# EUROPÄISCHE PATENTSCHRIFT

(11) **EP 2 564 281 B1**
(45) Veröffentlichungstag und Bekanntmachung des Hinweises auf die Patenterteilung: **05.09.2018**
(21) Anmeldenummer: 11706533.4
(22) Anmeldetag: 28.02.2011
(51) Int. Cl.: G05D 1/02, A01K 15/02

(54) **VERFAHREN ZUM ERKENNEN EINES ARBEITSBEREICHS SOWIE EIN GERÄT HIERFÜR**
METHOD FOR DETECTING A WORKING AREA AND DEVICE THEREFOR
PROCÉDÉ D'IDENTIFICATION D'UNE ZONE DE TRAVAIL ET APPAREIL ASSOCIÉ

(30) Priorität: 27.04.2010 DE 102010028251
(43) Veröffentlichungstag der Anmeldung: 06.03.2013
(73) Patentinhaber: Robert Bosch GmbH, 70442 Stuttgart (DE)
(72) Erfinder: PETEREIT, Steffen, 71691 Freiberg A. N. (DE); ALBERT, Amos, 71229 Leonberg (DE)
(74) Vertreter: Banse & Steglich Patentanwälte PartmbB
(86) Internationale Anmeldenummer: PCT/EP2011/052871
(87) Internationale Veröffentlichungsnummer: WO 2011/134696

(56) Entgegenhaltungen:
- EP-A2- 1 612 631
- US-A1- 2008 168 950
- kowoma.de: "The GPS System - Transmitted GPS Signals", , 19. April 2009 (2009-04-19), Seiten 1-3, XP002642236, Gefunden im Internet: URL:http://www.kowoma.de/en/gps/signals.ht m [gefunden am 2011-06-14]
- PRIGGE E A ET AL: "Signal Architecture for a Distributed Magnetic Local Positioning System", IEEE SENSORS JOURNAL, IEEE SERVICE CENTER, NEW YORK, NY, US, Bd. 4, Nr. 6, 1. Dezember 2004 (2004-12-01), Seiten 864-873, XP011122381, ISSN: 1530-437X, DOI: DOI:10.1109/JSEN.2004.833512
- E Martín Gorostiza ET AL: "A LOCAL POSITIONING SYSTEM BASED ON PSEUDO-RANDOM SEQUENCE EMISSION", 15th Triennial World Congress of the IFAC, 31. Dezember 2002 (2002-12-31), Seiten 1-4, XP55000746, Barcelona, Spain Gefunden im Internet: URL:http://www.nt.ntnu.no/users/skoge/pros t/proceedings/ifac2002/data/content/02983/ 2983.pdf [gefunden am 2011-06-15]

## Beschreibung

### Technisches Gebiet

Die Erfindung betrifft Geräte, die ihren Standort bezüglich eines definierten Bereichs automatisch erkennen und bei Erreichen oder Überschreiten einer Grenze des definierten Bereiches eine Funktion ausführen. Beispielsweise können derartige Geräte mobile Arbeitsgeräte sein, wie automatisch oder halbautomatisch arbeitende Bodenbearbeitungsmaschinen, z.B. Rasenmäher und dergleichen.

### Stand der Technik

Automatische oder halbautomatische mobile Arbeitsgeräte, wie beispielsweise Bodenbearbeitungsmaschinen, z.B. Rasenmäher, sollen sich in der Regel selbsttätig innerhalb eines definierten Arbeitsbereiches bewegen, ohne diesen zu verlassen. Eine Außengrenze des Arbeitsbereichs kann beispielsweise durch einen elektrischen Begrenzungsleiter bestimmt sein.

Der Begrenzungsleiter, der die Außengrenze des Arbeitsbereichs markiert, wird von einem elektrischen Strom durchflossen. Das resultierende elektrische bzw. magnetische Feld kann durch einen geeigneten Sensor in dem mobilen Arbeitsgerät detektiert werden, so dass das Arbeitsgerät bei Annäherung an die Begrenzung des Arbeitsbereiches eine Funktion durchführen kann. Bei automatischen mobilen Arbeitsgeräten kann beispielsweise vorgesehen sein, dass das mobile Arbeitsgerät wendet oder rückwärts fährt, um so den Arbeitsbereich nicht zu verlassen.

Bei einer einfachen Ausführung wird der Begrenzungsleiter von einem elektrischen Wechselstrom durchflossen. Das mobile Arbeitsgerät ist mit Detektionsspulen ausgestattet, in die durch das um den Begrenzungsleiter erzeugte magnetische Wechselfeld eine Wechselspannung induziert wird. Bei Annäherung an den stromdurchflossenen Begrenzungsleiter steigt die magnetische Feldstärke des Wechselfelds an, wodurch sich die Amplitude der induzierten Wechselspannung erhöht. Bei Erreichen einer festgelegten Schwelle für die Amplitude der induzierten Wechselspannung wird das mobile Arbeitsgerät angewiesen, sich von der Begrenzung des Arbeitsbereiches zu entfernen. Bei Überschreiten des Begrenzungsleiters kehrt sich die Richtung des magnetischen Wechselfelds um und damit ändert sich die Phasenlage der induzierten Wechselspannung, so dass das mobile Arbeitsgerät anhand des Phasenwechsels erkennen kann, ob es sich innerhalb oder außerhalb des Arbeitsbereichs befindet.

Aus den Druckschriften US 3,550,714, US 3,570,227, US 549,674, US 3,407,895, DE 16 13 991 und DE 19 02 037 sind einfache Arbeitsbereichsbegrenzungen für mobile Arbeitsgeräte bekannt, die auf einer Signalstärkenmessung eines von einem Begrenzungsleiter emittierten Signals basieren. Jedoch besteht ein Nachteil dieser Systeme darin, das nicht detektiert werden kann, auf welcher Seite des stromdurchflossenen Begrenzungsleiters sich die entsprechende Detektionsspule befindet, d.h. ob sich das Arbeitsgerät innerhalb oder außerhalb des definierten Arbeitsbereichs befindet. Insbesondere kann bei diesem Verfahren nicht festgestellt werden, ob sich dieses beim Einschalten des mobilen Arbeitsgerätes innerhalb oder außerhalb des Arbeitsbereiches befindet.

Bei weiterentwickelten Systemen, wie sie beispielsweise aus den Druckschriften WO 90/00274, EP 1 025 472, EP 1 047 983, DE 2 228 659 und US 3,299,351, US 5,438,266 bekannt sind, ist vorgesehen, den Begrenzungsleiter mit überlagerten Wechselströmen mit zwei oder mehr als zwei Frequenzen zu belegen. Wenn die Frequenzen der Wechselströme Vielfache voneinander sind und deren zeitliche Beziehung zueinander bekannt ist, kann anhand des Summensignals ermittelt werden, auf welcher Seite des Begrenzungsleiters sich das mobile Arbeitsgerät befindet.

Die Druckschrift EP 1 470 460 beschreibt ein System, das in begrenztem Umfang in der Lage ist, zu detektieren, ob sich die Detektionsspulen in dem mobilen Arbeitsgerät innerhalb oder außerhalb eines stromdurchflossenen Begrenzungsleiters befindet. Dazu werden die Amplituden der aktuell detektierten Signale mit der vorherigen Amplituden verglichen. Ein Mikroprozessor führt eine nummerische Analyse durch, um die Anzahl der Messungen zu ermitteln, die notwendig ist, um einen Schwellenwert zu erreichen und die ein Maß für den Abstand zu dem Begrenzungsleiter darstellt. Die numerische Analyse ermöglicht es, einen Phasenwechsel bei einer Überquerung des Begrenzungsleiters zu detektieren. Eine weitere Möglichkeit, ein Überqueren des Begrenzungsleiters zu detektieren, kann darin bestehen, dass die Signale von zwei Detektionsspulen, die an verschiedenen Positionen an dem mobilen Arbeitsgerät befestigt sind, verglichen werden. Dadurch kann eine Phasenverschiebung durch Überqueren des Begrenzungsleiters detektiert werden.

Die Druckschriften EP 1 512 053 und EP 1906 205 beschreiben jeweils ein System, bei dem der Begrenzungsleiter von periodischen Stromimpulsfolgen durchflossen wird. Das durch die Stromimpulsfolge generierte magnetische Feld wird von geeigneten Sensoren erfasst und die daraus resultierenden Spannungssignale zeitlich ausgewertet.

Nachteilig an den vorangehend beschriebenen Systemen ist, dass es notwendig ist, auf den Begrenzungsleiter Wechselströme von zwei oder mehr als Frequenzen einzuprägen und eine durch einen Stromimpuls getriggerte Zeitauswertung der Signale durchzuführen.

In der Druckschrift EP 1 612 631 wird ein System beschrieben, das eine Auswertung ohne ein Stromtriggersignal durchführen kann. Jedoch ist es bei diesem System notwendig, das mobile Arbeitsgerät einzuschalten, während es sich innerhalb des Arbeitsbereiches befindet. Nach Einschalten des mobilen Arbeitsgeräts wird eine sich in dem Arbeitsgerät befindliche Uhr mit dem Signal des Begrenzungsleiters synchronisiert. Dadurch kann das Arbeitsgerät Phasenwechsel beim Überqueren des Begrenzungsleiters detektieren.

Die Druckschrift EP 1 612 631 A2 offenbart ein System zum Nachverfolgen der Position eines obigen Geräts hinsichtlich einer Umfanqslinie eines Bereichs, der durch einen Begrenzungsleiter umgeben ist. In den Begrenzungsleiter wird ein elektrisches Steuersignal eingeprägt, das ein magnetisches Feld generiert. In dem Gerät wird ein Detektionssignal abhängig von dem generierten magnetischen Feld empfangen und bei Einschalten des Geräts wird ein dem Detektionssignal entsprechendes Referenzsignal erzeugt, das in Phase zu dem elektrischen Steuersignal ist. Durch kontinuierliches Überwachen der Phasenlage zwischen dem Detektionssignal und dem Referenzsignal kann erkannt werden, ob sich das Gerät innerhalb oder außerhalb des Bereichs befindet.

Die Druckschrift "The GPS System", http//www.kowoma.de/en/gps/signals.htm offenbart die Verwendung von Pseudo-Zufallssignalen für ein GPS-Svstem.

Die Druckschrift Erik A. Prigge, "Signal architecture for a distributed magnetic local positioning system" IEEE Sensors Journal, Band 4, Nr. 6, Dezember 2004 beschreibt die Verwendung eines Pseudo-Zufallssignals für ein Positionsbestimmungssystem basierend auf einem niederfrequenten magnetischen Feld.

Die Druckschrift E. M. Gorostiza et al., "A local positioning system based on pseudo-random sequence emission", 15th Trienniel World Congress, Barcelona, Spanien beschreibt die Verwendung von pseudozufälligen Signalfolgen für die Positionsbestimmung.

Es ist Aufgabe der vorliegenden Erfindung, ein Gerät und ein Verfahren zum Betreiben eines Gerätes zur Verfügung zu stellen, wobei das Gerät ohne vorheriges Einlernen, in welchem Bereich es sich befindet, z.B. bereits unmittelbar nach dem Einschalten, erkennen kann, ob es sich innerhalb oder außerhalb eines definierten Bereichs befindet.

### Offenbarung der Erfindung

Diese Aufgabe wird durch das Verfahren zum erkennen einer Position bezüglich eines definierten Bereichs gemäß Anspruch 1 sowie durch das Gerät und das System gemäß den nebengeordneten Ansprüchen gelöst.

Weitere vorteilhafte Ausgestaltungen sind in den abhängigen Ansprüchen angegeben.

Gemäß einem ersten Aspekt ist ein Verfahren zum Erkennen einer Position bezüglich eines definierten Bereichs, insbesondere in einem mobilen Arbeitsgerät, vorgesehen. Das Verfahren umfasst die folgenden Schritte:
- Bereitstellen eines Stromsignals in einem Begrenzungsleiter, der den definierten Bereich umgibt, entsprechend eines bereitgestellten Begrenzungssignals, wobei das Begrenzungssignal einem Pseudozufallssignal entspricht;
- Empfangen eines Detektionssignals eines durch das Stromsignal in dem Begrenzungsleiter generierten magnetischen Feldes;
- Generieren eines rekonstruierten Begrenzungssignals aus dem Detektionssignal;
- Bereitstellen eines Referenzsignals, das ein dem bereitgestellten Begrenzungssignal entsprechendes Bitmuster aufweist;
- Durchführen eines Korrelationsverfahrens, um einen zeitlichen Korrelationsversatz zwischen dem Referenzsignal und dem rekonstruierten Begrenzungssignal und einen Korrelationswert zwischen dem Referenzsignal und dem rekonstruierten Begrenzungssignal, die um den ermittelten Korrelationsversatz zueinander verschoben sind, zu ermitteln;
- Bestimmen einer Position innerhalb oder außerhalb des definierten Bereichs abhängig von dem ermittelten Korrelationswert.

Gemäß einem weiteren Aspekt ist ein Verfahren zum Erkennen einer Position bezüglich eines durch ein magnetisches Wechselfeld definierten Bereichs vorgesehen. Das Verfahren umfasst die folgenden Schritte:
- Empfangen eines Detektionssignals, das einer durch das magnetische Wechselfeld induzierten Spannung entspricht;
- Generieren eines rekonstruierten Begrenzungssignals aus dem Detektionssignal;
- Bereitstellen eines Referenzsignals, wobei das rekonstruierte Begrenzungssignal und das Referenzsignal einem Pseudozufallssignal entsprechen;
- Durchführen eines Korrelationsverfahrens, um einen zeitlichen Korrelationsversatz zwischen dem Referenzsignal und dem rekonstruierten Begrenzungssignal und einen Korrelationswert zwischen dem Referenzsignal und dem rekonstruierten Begrenzungssignal, die um den ermittelten Versatz zueinander verschoben sind, zu ermitteln;
- Bestimmen einer Position innerhalb oder außerhalb des Bereichs abhängig von dem ermittelten Korrelationswert.

Eine Idee des obigen Verfahrens besteht darin, dass wie bei den bisherigen Systemen der Arbeitsbereich durch einen Begrenzungsleiter eingegrenzt wird. Auf den Begrenzungsleiter wird ein Stromsignal eingeprägt, das ein entsprechendes magnetisches Wechselfeld generiert. Das Stromsignal wird aus einem bereitgestellten Begrenzungssignal generiert, das einer zufälligen periodischen Signalabfolge entspricht. Die Signalabfolge des Begrenzungssignals ist dem Gerät bekannt. Mit Hilfe eines Korrelationsverfahren in dem Gerät erfolgt eine Synchronisation des Referenzsignals auf das rekonstruierte Begrenzungssignal oder umgekehrt. Bei einem Feststellen, dass das Begrenzungssignal und das Referenzsignal korreliert, wird erkannt, ob sich ein Gerät innerhalb oder außerhalb eines bestimmten durch den Begrenzungsleiter definierten Bereichs befindet.

Das obige Verfahren hat den Vorteil, dass die Korrelation des rekonstruierten Begrenzungssignals mit einem Referenzsignal mit geringem Rechenaufwand in einem mobilen Gerät durchführbar ist, so dass detektierbar ist, ob sich das mobile Gerät innerhalb oder außerhalb eines durch einen Begrenzungsleiter definierten Bereichs befindet. Dies gilt insbesondere bereits bei Einschalten des Gerätes, ohne dass ein vorhergehendes Einlernen erforderlich ist.

Vorzugsweise werden als Sendesignal Pseudo-Zufallssignale verwendet, die sehr günstige Frequenzspektrum-Eigenschaften aufweisen, so dass sich eine sehr hohe Zuverlässigkeit des Verfahrens auch bei störungsintensiven Umgebungsbedingungen ergibt. Ferner ist die Erzeugung dieser Signale in einfacher Weise möglich z.B. mit Hilfe eines Schieberegisters und Logikgatter, wie z.B. einem Exklusiv-ODER-Gatter.
Insbesondere besteht ein weiterer Vorteil darin, dass kein Einlernen, in welchem Bereich sich das Gerät befindet, unmittelbar nach dem Einschalten des Geräts durchgeführt werden muss. Es wird lediglich durch Anwenden des Korrelationsverfahrens überprüft, ob eine Korrelation zwischen dem empfangenen rekonstruierten Begrenzungssignal und dem Referenzsignal vorliegt oder nicht. Liegt eine Korrelation vor, kann das Gerät erkennen, ob sich das Gerät innerhalb des Bereichs befindet. Darüber hinaus ist es vorteilhaft, dass das gesendete Begrenzungssignal permanent gesendet wird, so dass etwaige Störungen überlagert werden.

Die Implementierung von Korrelationsverfahren stellt darüber hinaus keine hohe Anforderung an die Auswerteelektronik, und es ist möglich, in den Begrenzungsleiter einen geringeren Strom einzuprägen als dies bei den bisher realisierten Systemen der Fall ist. Aufgrund der Fehlertoleranzen der Korrelationsverfahren können nämlich geringe Magnetfeldstärken des durch die eingeprägten Ströme erzeugten Magnetfeldes in Kauf genommen werden.

Weiterhin kann das Pseudozufallssignal ein binäres Signal mit einer quasi-zufälligen Abfolge von Pegeln sein und einem periodischem Bitmuster entsprechen, das so ausgewählt ist, dass eine Länge eines Abschnitts des periodischen Bitmusters, der zu einem gleich langen Abschnitt des invertierten Bitmusters identisch ist, bezüglich der gesamten Länge des Bitmusters einen vorgegebenen Anteil unterschreitet.

Weiterhin kann das Begrenzungssignal einem Gold-Code entsprechen.

Gemäß einer Ausführungsform kann der zeitliche Korrelationsversatz zwischen dem Referenzsignal und dem rekonstruierten Begrenzungssignal ermittelt werden, indem mehrere Korrelationswerte bei verschiedenen zeitlichen Versatzen bestimmt werden und der zeitliche Korrelationsversatz als der zeitliche Versatz bei dem betragsmäßig größten Korrelationswert bestimmt wird.

Der Korrelationswert kann mit Hilfe einer Kreuzkorrelationsfunktion, durch Addition oder Multiplikation von Abtastwerten des rekonstruierten Begrenzungssignals und von Zeitwerten des Referenzsignals bestimmt werden.

Gemäß einem weiteren Aspekt ist ein Gerät, insbesondere ein mobiles Arbeitsgerät, vorgesehen. Das Gerät umfasst:
- eine Detektoreinheit zum Empfangen eines Detektionssignals eines durch das Stromsignal in dem Begrenzungsleiter generierten magnetischen Feldes;
- einen Referenzsignalgenerator zum Bereitstellen eines Referenzsignals, das ein dem bereitgestellten Begrenzungssignal entsprechendes Bitmuster aufweist;
- eine Auswerteeinheit, die ausgebildet ist,
   - um ein rekonstruiertes Begrenzungssignal aus dem Detektionssignal zu generieren,
   - um ein Korrelationsverfahren durchzuführen, um einen zeitlichen Korrelationsversatz zwischen dem Referenzsignal und dem rekonstruierten Begrenzungssignal und einen Korrelationswert zwischen dem Referenzsignal und dem rekonstruierten Begrenzungssignal, die um den ermittelten Versatz zueinander verschoben sind, zu ermitteln; und
   - um eine Position innerhalb oder außerhalb des Bereichs abhängig von dem ermittelten Korrelationswert zu bestimmen.

Gemäß einem weiteren Aspekt ist ein Begrenzungssignalgenerator zum Bereitstellen eines Stromsignals in einem Begrenzungsleiter, der einen definierten Bereich umgibt, entsprechend einem bereitgestellten Begrenzungssignal vorgesehen, wobei das Begrenzungssignal einem Pseudozufallssignal entspricht.

Gemäß einem weiteren Aspekt ist ein System zum Erkennen einer Position bezüglich eines Bereichs vorgesehen. Das System umfasst:
- einen Begrenzungsleiter, der den Bereich umgibt;
- das obige Gerät, und
- der obige Begrenzungssignalgenerator, der ein Stromsignal in den Begrenzungsleiter einprägt.

Gemäß einem weiteren Aspekt ist ein Computerprogrammprodukt vorgesehen, das einen Programmcode enthält, der, wenn er auf einer Datenverarbeitungseinheit ausgeführt wird, das obige Verfahren durchführt.

Gemäß einem weiteren Aspekt ist eine Verwendung des obigen Systems in einem mobilen Arbeitsgerät vorgesehen, bei dem eine Bewegung des mobilen Arbeitsgerät nur innerhalb des Bereiches zugelassen wird und bei dem bei Erreichen des Begrenzungsleiters eine Richtungsänderung des mobilen Arbeitsgeräts durchgeführt wird.

Gemäß einem weiteren Aspekt ist eine Verwendung des obigen Systems in einem Überwachungsgerät vorgesehen, bei dem eine Funktion des Überwachungsgeräts bei Verlassen des Bereichs ausgelöst wird.

Gemäß einem weiteren Aspekt ist eine Verwendung des obigen Systems in einem Verfolgungsgerät vorgesehen, bei dem das Verfolgungsgerät eine Richtungsänderung in Richtung des Begrenzungsleiters ausführt, wenn die Position des Verfolgungsgeräts als innerhalb oder außerhalb des Bereichs erkannt wird.

### Kurzbeschreibung der Zeichnungen

Bevorzugte Ausführungsformen werden nachfolgend anhand der beigefügten Zeichnungen näher erläutert. Es zeigen:
- Figur 1: eine schematische Darstellung eines Systems mit einem mobilen Arbeitsgerät für eine Bodenbearbeitung innerhalb eines Arbeitsbereiches;
- Figur 2: eine schematische Darstellung einer weiteren Ausführungsform eines Systems mit einem mobilem Arbeitsgerät in einem Arbeitsbereich, der durch mehrere ineinander liegende Begrenzungsleiterschleifen ausgebildet ist;
- Figur 3: eine Darstellung der zeitlichen Verläufe des von dem Begrenzungsleiter generierten Begrenzungssignals und eines von der Auswerteeinheit des mobilen Arbeitsgeräts rekonstruiertes Begrenzungssignals und des von dem Referenzsignalgenerator des mobilen Arbeitsgerätes erzeugtes Referenzsignal;
- Figur 4: eine Blockdarstellung eines Signalgenerators zum Generieren eines Pseudo-Zufallssignals mit Hilfe eines Schieberegisters;
- Figur 5: eine Flußdiagramm zur Veranschaulichung des Verfahrens zum erkennen eines Bereichs;
- Figur 6: eine Darstellung der zeitlichen Verläufe des rekonstruierten Begrenzungssignals und des Referenzsignals;
- Figur 7a bis 7c: verschiedene Kombinationsergebnisse für ein 5-Bit Pseudo-Zufallssignal dargestellt über der Abtastverschiebung ε, für den Fall, dass sich das Arbeitsgerät innerhalb des Arbeitsbereiches befindet, für den Fall, dass sich das Arbeitsgerät außerhalb des Arbeitsbereiches befindet und für den Fall, dass kein Empfangssignal empfangen wird oder das rekonstruierte Begrenzungssignal eine andere Kodierung aufweist als das Referenzsignal.

### Beschreibung von Ausführungsformen

Die Erfindung betrifft im allgemeinen Gerät, die erkennen können, ob sie sich innerhalb oder außerhalb eines definierten Bereichs befinden. Insbesondere können diese Geräte mobile Arbeitsgeräte oder Überwachungsgeräte sein.

Mobile Arbeitsgeräte können beispielsweise automatische oder halbautomatische Arbeitsgeräte für eine Bodenbearbeitung sein und Aufgaben, wie z.B. Rasen mähen, Vertikutieren, Aerifizieren, Laub sammeln, Garten bewässern, Garten/Rasenfläche düngen, Schnee räumen und im häuslichen Bereich Staubsaugen, Boden wischen, Boden waschen, Boden polieren und dergleichen übernehmen. Im industriellen Bereich können die Bodenbearbeitungsaufgaben das Präparieren von Eisflächen und das Staubsaugen / Wischen / Wachsen / Polieren von Böden in Hallen und dergleichen umfassen.

Bei alternativen Ausführungsformen kann das Gerät kann auch als Überwachungsgerät ausgebildet sein, um zu überwachen, ob eine Person, ein Tier oder ein Gegenstand sich aus einem vorgegebenen Überwachungsbereich hinausbewegt, so dass es z.B. für Anwendungen bezüglich eines virtuellen Zauns für Haustiere, für einen Diebstahlschutz von Geräten, wie z.B. von Fahrzeugen, oder für eine elektronische Fußfessel geeignet ist.

Im Folgenden wird die Erfindung anhand eines automatischen mobilen Arbeitsgeräts beschrieben.

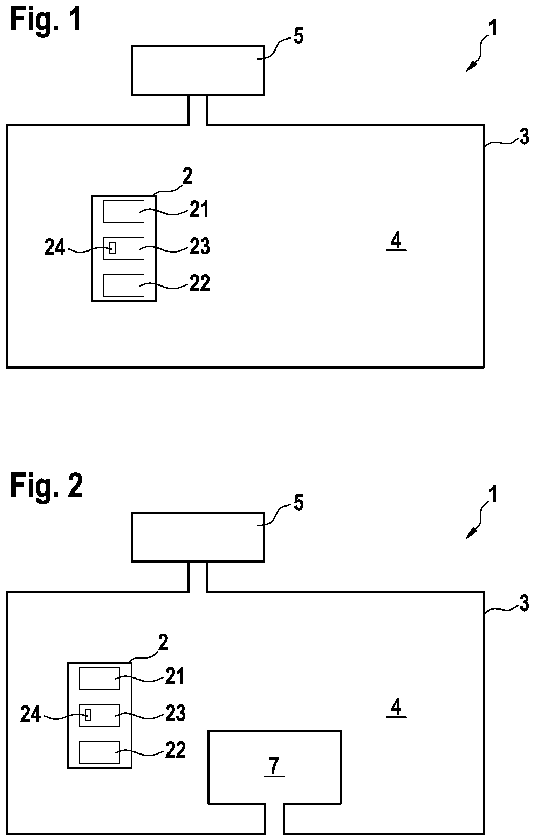

Figur 1 zeigt als eine mögliche Ausführungsform ein System 1 mit einem mobilen Arbeitsgerät 2, das sich innerhalb eines durch einen Begrenzungsleiter 3 definierten Arbeitsbereichs 4 befindet.

Der Begrenzungsleiter 3 ist vorzugsweise in den Boden eingelassen oder darauf angebracht. Der Begrenzungsleiter 3 ist in Form einer Leiterschleife ausgebildet und definiert in seinem Inneren einen Arbeitsbereich 4, den das mobile Arbeitsgerät nicht verlassen soll. Erreicht das mobile Arbeitsgerät den Begrenzungsleiter 3 soll eine Funktion ausgeführt werden. Diese Funktion kann beispielsweise die Fahrrichtungsumkehr oder eine Richtungsänderung sein.

Der Begrenzungsleiter 3 ist mit einem Begrenzungssignalgenerator 5 verbunden, der auf die Leiterschleife des Begrenzungsleiters 3 ein Begrenzungssignal BS als Stromsignal einprägt. Das Begrenzungssignal wird, wie nachfolgend beschrieben, als Abfolge von vorzugsweise binären Signalpegeln gemäß einer von einem Begrenzungssignal-Oszillator 51 erzeugten Begrenzungssignal-Frequenz erzeugt.

Der Stromfluss des Stromsignals bewirkt, dass sich um den Begrenzungsleiter 3 ein magnetisches Wechselfeld ausbildet, dessen Stärke und Richtung von der Stromstärke und -richtung des Begrenzungssignals abhängt. Aufgrund der Schleifenform des Begrenzungsleiters 3 ist die Richtung des magnetischen Wechselfelds im gesamten Inneren des von dem Begrenzungsleiter 3 umgebenden Arbeitsbereichs 4 gleichgerichtet und außerhalb des durch den Begrenzungsleiter 3 umgebenden Arbeitsbereichs um 180° phasenversetzt zu dem magnetischen Wechselfeld.

Das mobile Arbeitsgerät 2 umfasst eine Detektoreinheit 21, um das durch den Begrenzungsleiter 3 erzeugte magnetische Wechselfeld und dessen Richtung zu detektieren. Üblicherweise wird die Detektoreinheit 21 mit Hilfe einer oder mehrere Induktionsspulen ausgebildet, in denen eine elektrische Spannung abhängig von dem magnetischen Wechselfeld, das durch das auf den Begrenzungsleiter 3 eingeprägte Stromsignal erzeugt wird, induziert wird. Diese induzierte Spannung wird im Folgenden als Detektionssignal bezeichnet.

Das Detektionssignal wird einer Auswerteeinheit 22 durchgeführt. Die Auswerteeinheit 22 analysiert das Detektionssignal von der Detektoreinheit 21 und generiert aus dem Detektionssignal das in den Begrenzungsleiter 3 eingeprägte Begrenzungssignal BS. Da Induktionsspulen nur Änderungen des Magnetfeldes als Spannungsspitze detektieren können, werden daher in der Auswerteeinheit 22 die Spannungsspitzen entsprechend ihrem Vorzeichen als Pegelwechselsignal interpretiert. Wenn es sich bei dem Begrenzungssignal BS, das auf den Begrenzungsleiter 3 eingeprägt wird, um ein binäres Stromsignal handelt, so kann jede Spannungsspitze des Detektionssignals als Pegelwechsel interpretiert werden. Die Auswerteeinheit 22 rekonstruiert auf diese Weise das angelegte Begrenzungssignal im mobilen Arbeitsgerät 2 und stellt dieses als rekonstruiertes Begrenzungssignal zur Verfügung.

Das mobile Arbeitsgerät 2 umfasst weiterhin einen Referenzsignalgenerator 23, der ein Referenzsignal generiert, das in der Signalfolge im Wesentlichen dem durch den Begrenzungssignalgenerator 5 vorgegebenen Begrenzungssignal entspricht. Der Referenzsignalgenerator 23 umfasst dazu einen Referenzsignal-Oszillator 24, der für das Referenzsignal eine gleiche Basisfrequenz bereitstellt, wie der Begrenzungssignal-Oszillator 51 in dem Begrenzungssignalgenerator 5 für die Generierung des Begrenzungssignals bereitstellt. Eine Synchronisation des Referenzsignals auf das Begrenzungssignal auf dem Begrenzungsleiter 3 besteht zumindest zum Zeitpunkt des Einschaltens des mobilen Arbeitsgerätes 1 nicht.

In Figur 2 ist eine weitere Gestaltung des Arbeitsbereiches 4 dargestellt, bei dem innerhalb des Arbeitsbereiches 4 ein Inselbereich 7 vorgesehen ist, der als Bereich außerhalb des Arbeitsbereichs 4 für das mobile Arbeitsgerät 2 angesehen wird. Werden, wie in dem Abschnitt 8 des Begrenzungsleiters 3, der den Inselbereich mit dem Außenrand des Arbeitsbereichs 4 verbindet, dargestellt, zwei Abschnitte des Begrenzungsleiters 3 nah beieinander geführt, so ist dies für die Detektionseinheit 21 des mobilen Arbeitsgerätes 2 im wesentlichen unsichtbar, da die Stromrichtungen in diesen zwei Abschnitten bei Ausbildung des Begrenzungsleiters 3 in einer Leiterschleife in der Regel gegenläufig sind und sich die dadurch erzeugten magnetischen Wechselfelder gegenseitig auslöschen.

Der Begrenzungssignalgenerator 5 und der Referenzsignalgenerator 23 in dem mobilen Arbeitsgerät 2 generieren im Wesentlichen ein identisches Signal, das als Pseudo-Zufallssignal aus einer pseudo-zufälligen Abfolge einer vorgegebenen Anzahl von Bits besteht. Das Pseudo-Zufallssignal wird periodisch bereitgestellt. Das Pseudo-Zufallssignal wird auch als PRN (Pseudo Random Noise) oder PRBS (Pseudo Random Binary Signal) bezeichnet. Die Pseudo-Zufallssignale, die in dem Begrenzungssignalgenerator 5 und in dem Referenzsignalgenerator 23 generiert werden, sind zueinander nicht synchronisiert und es gibt keinen expliziten Anfangszeitpunkt oder ein Anfangsmuster.

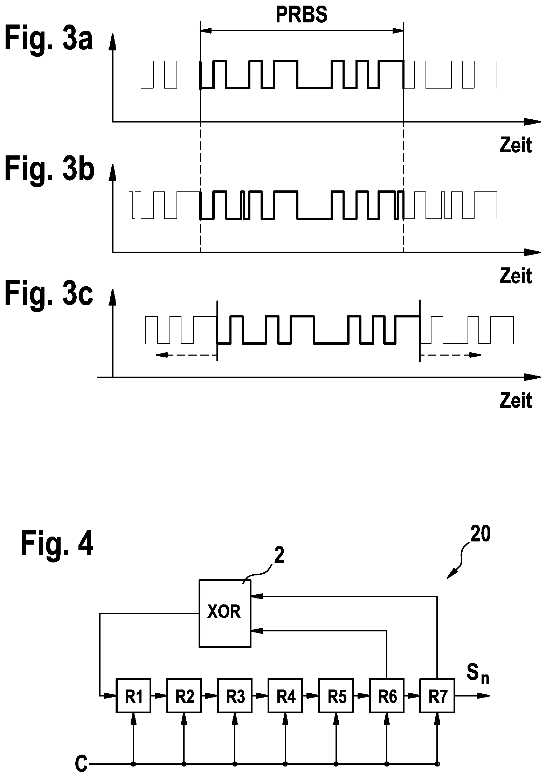

Beispielhafte Verläufe für ein Begrenzungssignal, ein Referenzsignal und ein von der Detektoreinheit 21 empfangenes mit Störungen behaftetes rekonstruiertes Begrenzungssignal sind in Figur 3 dargestellt. Figur 3a zeigt ein vom Begrenzungssignalgenerator 5 erzeugtes Begrenzungssignal, das in ein entsprechendes Stromsignal umgewandelt wird, das in den Begrenzungsleiter 3 eingeprägt wird. Der Verlauf des durch den Stromfluss erzeugten magnetischen Wechselfelds entspricht im Wesentlichen einem Verlauf des Begrenzungssignals.

Figur 3b zeigt ein entsprechendes rekonstruiertes Begrenzungssignal, das aus dem Detektionssignal in der Detektionseinheit 21 des mobilen Arbeitsgerätes 2 erzeugt wird, und mit Störungen behaftet ist. Man erkennt, dass das Detektionssignal im Wesentlichen dem Begrenzungssignal entspricht, und dass zwischen dem Begrenzungssignal und dem Detektionssignal kein nennenswerter Versatz vorliegt.

In Figur 3c ist ein Referenzsignal dargestellt, wie es in dem Referenzsignalgenerator 23 erzeugt wird. Der Referenzsignalgenerator 23 erzeugt das Referenzsignal auf die gleiche Weise wie der Begrenzungssignalgenerator 5, so dass die gleiche Abfolge von Bits mit der gleichen Signalfrequenz bereitgestellt wird, wie das Begrenzungssignal.

Pseudo-Zufallssignale sind in einfacher Weise zu erzeugen, z.B. durch Einsatz eines linear gekoppelten Schieberegisters 20 (Linear Feedback Shift Register) wie es beispielsweise in dem Blockschaltbild der Figur 4 dargestellt ist. Man erkennt eine Serienschaltung von sieben Latchen 21 (Registerschaltungen), d.h. eines ersten bis siebten Latches, die in Form eines Schieberegisters 20 seriell verschaltet sind. Das Schieberegister 20 wird durch ein Taktsignal C getaktet, so dass bei einer Flanke des Taktsignals C der Eingang jedes der Latche 21 an seinen Ausgang angelegt wird. Die Ausgänge von zwei der Latche 21, hier des sechsten und des siebten Latches, sind auf ein Exklusiv-ODER-Gatter 22 zurückgeführt, dessen Ausgang mit dem Eingang des ersten Latch 21 verbunden ist. Aus so einer Verschaltung ergibt sich bei einem bestimmten Anfangszustand ein serielles 128-Bit Zufallsmuster am Ausgang des siebten Latchs 21, ohne das sich innerhalb dieses Bitmusters eine vollständige Wiederholung von Signalmustern ergibt. Diese pseudozufälligen Signalfolgen werden Gold-Codes genannt. Weiterhin kann mit einer solchen Schaltung die Abfolge des 128-Bit großen Pseudo-Zufallssignals periodisch widerholt werden, ohne dass sich ein Totlaufen ergibt.

Wesentlich für die Pseudo-Zufallssignale ist, dass bei periodischer Wiederholung des zufälligen Bitmusters keine Abschnitte des Pseudo-Zufallssignals mit Abschnitten des inversen Pseudo-Zufallssignals, bei dem Logikpegel des Pseudo-Zufallssignals jeweils invertiert sind, identisch sind. Die Länge des zu dem inversen Pseudo-Zufallssignal identischen Abschnitts des Bitmusters darf einen vorgegebenen Anteil bezogen auf die Länge des gesamten Bitmusters nicht übersteigen, da ansonsten keine ausreichende Diskriminierung durch die Korrelation möglich ist.

Ein beispielhaftes 5-Bit-Schieberegister gleicher Bauart ermöglicht Gold-Codes mit jeweils 31-Bit Signallänge. Diese Gold-Codes können beispielsweise mit Hilfe von sogenannten DIP-Schaltern in den Signalgeneratoren vorgegeben werden, um so die Abstimmung zwischen dem Begrenzungssignalgenerator 5 und dem Referenzsignalgenerator 23 zu individualisieren, insbesondere wenn mehrere mobile Arbeitsgeräte gleicher Bauart nah beieinander verwendet werden. Je länger das Schieberegister 20 ist umso mehr geeignete Zufallssignalmuster lassen sich unterscheiden. Grundsätzlich sind viele verschiedene Möglichkeiten denkbar, solche sich wiederholenden Zufallssignalmuster zu generieren, die in dem beschriebenen Gerät angewendet werden können.

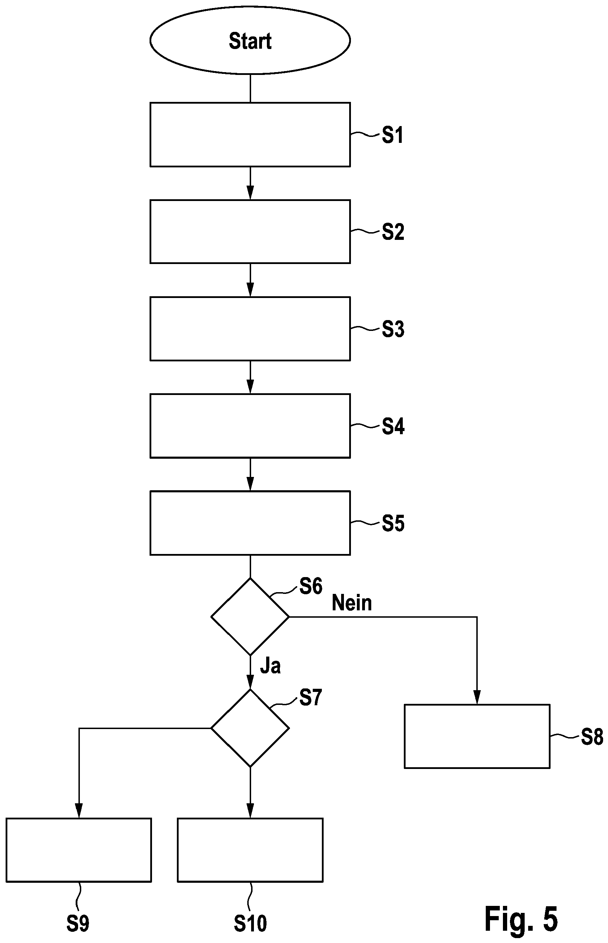

Das Verfahren zum erkennen, in welchem Bereich sich das Arbeitsgerät befindet, wird nachfolgend in Verbindung mit dem Flußdiagramm der Fig. 5 beschrieben.

Nach dem Empfangen des Detektionssignals durch die Detektionseinheit 21 in Schritt S1 erhält die Auswerteeinheit 22 in Schritt S2 das von der Detektionseinheit 21 empfangene Detektionssignal und wandelt dieses in Schritt S3 in das rekonstruierte Begrenzungssignal um. Gemäß Schritt S4 wird von dem Referenzsignalgenerator 23 das Referenzsignal generiert. Das rekonstruierte Begrenzungssignal wird in der Auswerteeinheit 22 in Schritt S5 mit dem von dem Referenzsignalgenerator 23 generierten Referenzsignal korreliert. Da das Referenzsignal und das Begrenzungssignal durch die gleiche Zufallsfunktion erzeugt werden, insbesondere durch die gleiche Hardware, z.B. in Form des Schieberegisters 20, ist das Pseudo-Zufallssignal identisch und periodisch. Bei Verwendung einer gleichen Oszillatorfrequenz für die Erzeugung der Pseudo-Zufallssignale können die Pseudo-Zufallssignale also miteinander korreliert werden. In Schritt S6 wird also abgefragt, ob eine Korrelation vorliegt, d.h. sich das Referenzsignal RS und das rekonstruierte Begrenzungssignal BS zueinander korrelieren lassen. Ist dies der Fall (Alternative: Ja), so ist das Arbeitsgerät 2 auf den Begrenzungssignalgenerator 5 abgestimmt. Durch eine nachfolgende Überprüfung des Korrelationswertes in Schritt S7 wird festgestellt, ob sich das Arbeitsgerät 2 innerhalb (Schritt S9) oder außerhalb des Arbeitsbereiches 4 (Schritt S10) befindet, was in geeigneter Weise signalisiert wird oder zum Durchführen oder Beibehalten bestimmter Funktionen (Beibehalten der Bewegungsrichtung, Richtungsumkehr) führt. Liegt gemäß Schritt S6 keine Korrelation vor (Alternative: Nein), d.h. das Referenzsignal RS und das rekonstruierte Begrenzungssignal BS lassen sich nicht zueinander korrelieren, so wird eine Notfunktion, wie z.B. ein Stoppen des Arbeitsgerät in Schritt S8 ausgelöst.

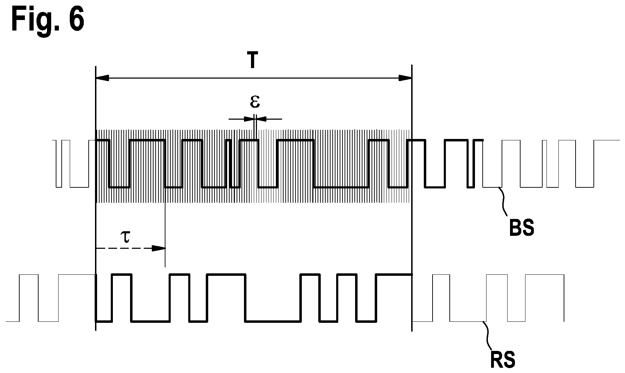

Zur Korrelation werden das Referenzsignal und das rekonstruierte Begrenzungssignal mit einer höheren Frequenz abgetastet, wie z.B. dem vier- bis zehnfachen der Oszillationsfrequenz der Signalgeneratoren. Die Abtastung des rekonstruierten Begrenzungssignals BS und des Referenzsignals RS ist in Figur 6 als zeitlicher Verlauf der Signale dargestellt.

Die Abtastwerte des Begrenzungssignals BS(i) und des Referenzsignals RS(i) werden zur Synchronisation miteinander verglichen und ein Kreuzkorrelationsfunktionswert KKF gemäß folgender Formel ermittelt. $K K F \left(τ\right) = \frac{1}{N} {\sum }_{i = 1}^{N - 1} \overline{X O R} \left(R S \left(i\right) , B S \left(i - τ\right)\right)$ wobei i einem Abtastzeitpunkt entspricht.

Die Kreuzkorrelationswerte KKF werden für mehrere Signalverschiebungen ermittelt, bei denen die beiden Signale zueinander um ganzzahlige Vielfache einer Abtastzeitdauer ε, die die Zeitdauer zwischen den Abtastungen angibt, zueinander verschoben werden und die Kreuzkorrelationswerte KKF erneut berechnet werden.

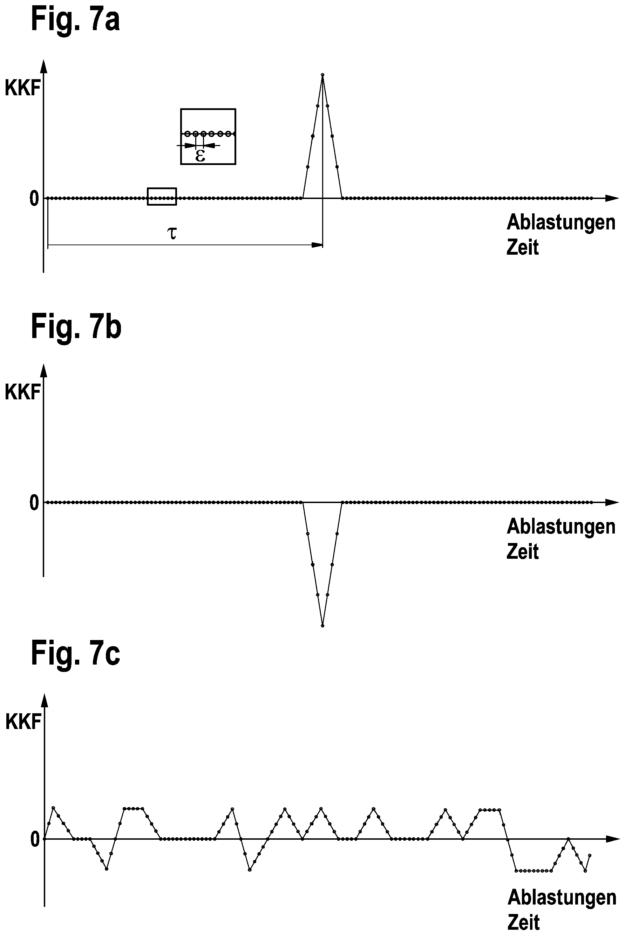

Es ergeben sich, wie in Figuren 7a-7c dargestellt für verschiedene zeitlich Versatze zwischen dem Detektionssignal DS und dem Referenzsignal RS Kreuzkorrelationswerte KKF, wie sie in den Figuren 7a-7c dargestellt sind, wobei sich N=T/ε aus der Anzahl N der Abtastungen während einer Periode T des Begrenzungssignals ergibt.

Es wird angemerkt, dass die Korrelation auch anderweitig berechnet werden kann, z.B. als Multiplikation des Referenzsignalwertes RS und des Detektionssignalwertes DS zu einem bestimmten Abtastzeitpunkt oder z.B. durch ein Addieren des rekonstruierten Begrenzungssignals und des Referenzsignals und einem anschließenden Glätten des Additionsergebnis.

Der Kreuzkorrelationswert KKF entspricht dem sogenannten Summenergebnis und wird auch als Trefferzahl bezeichnet. Denn immer wenn RS(i) und BS(i-τ) identisch sind, ergibt der Summand den Wert 1 ansonsten den Wert 0.

Um ein relatives Maß für den Kreuzkorrelationswert KKF zu erhalten, wird das Ergebnis der Summenbildung durch die Anzahl N der Abtastungen dividiert. Die obige Korrelationsfunktion führt zu einem Wert von etwa 1, wenn sich das mobile Arbeitsgerät 2 im Inneren des durch den Begrenzungsleiter 3 definierten Arbeitsbereiches 4 befindet. Befindet sich das mobile Arbeitsgerät 2 außerhalb des Arbeitsbereiches 4, so weist das durch den Begrenzungsleiter 3 erzeugte magnetische Wechselfeld eine entgegengesetzte Richtung auf (180° phasenverschoben), so dass das rekonstruierte Begrenzungssignal BS für korrespondierende Signalteile im Vergleich zu dem Inneren des Arbeitsbereiches 4 ein negatives Vorzeichen hat. In diesem Fall ist das rekonstruierte Begrenzungssignal invers zu dem Referenzsignal korreliert und man erhält auf diese Weise ein Kreuzkorrelationswert von -1.

Da beim Empfangen des Detektionssignals Störungen auftreten können, kann es vorkommen, dass durch die obige Kreuzkorrelationfunktion ermittelte Kreuzkorrelationswert nicht exakt 1 oder -1 entspricht, sondern davon abweichende Werte aufweisen kann, je nachdem, ob eines oder mehrere Bits des pseudozufälligen Begrenzungssignals mit dem pseudozufälligen Referenzsignal nicht übereinstimmen. Aus diesem Grunde wird zur Feststellung, ob eine Korrelation oder eine inverse Korrelation vorliegt, der Kreuzkorrelationswert nicht mit 1 bzw. -1 verglichen, sondern es wird überprüft, ob der entsprechende Kreuzkorrelationswert KKF innerhalb eines vorgegebenen Toleranzbereiches um 1 bzw. -1 liegt. Liegt der Kreuzkorrelationswert KKF innerhalb des definierten Toleranzbereichs, so wird eine Korrelation festgestellt und damit festgestellt, dass sich das mobile Arbeitsgerät 2 innerhalb des Arbeitsbereiches bzw. außerhalb des Arbeitsbereiches befindet.

In den Figuren 7a bis 7c sind Kreuzkorrelationswerte KKF über verschiedene zeitliche Versatze aufgetragen. Man erkennt, dass bei einem bestimmten zeitlichen Versatz ein Maximum (in Figur 7a) bzw. ein Minimum (in Fig. 7b) des Kreuzkorrelationswertes KKF erreicht wird. Kann ein solches Maximum bzw. Minimum festgestellt werden, dessen Kreuzkorrelationswert KKF oberhalb eines durch den Toleranzbereich bestimmten vorgegebenen positiven Korrelationsschwellenwerts, wie z.B. 0,8 bzw. 0,9 oder unterhalb eines durch den Toleranzbereich bestimmten negativen Korrelationsschwellenwertes von z.B. -0,8 bzw. - 0,9 liegt, so stellt der entsprechende zeitliche Versatz die Phasenverschiebung zwischen dem rekonstruierten Begrenzungssignal BS und dem Referenzsignal RS dar.

Überschreitet der ermittelte Korrelationswert den positiven Korrelationsschwellenwert nicht bzw. unterschreitet der ermittelte Kreuzkorrelationswert KKF den negativen Korrelationsschwellenwert nicht, so kann festgestellt werden, dass das Begrenzungssignal BS eine andere Kodierung aufweist als das Referenzsignal RS oder das kein Drahtsignal empfangen wird. Ein solcher Fall ist in dem Diagramm der Figur 7c dargestellt.

Ist die Verschiebung τ durch die Lage der Kreuzkorrelation KKF bestimmt, kann das in dem mobilen Arbeitsgerät 2 erzeugte Referenzsignal RS nun um τ verschoben werden, so dass die beiden Signale, d.h. das rekonstruierte Begrenzungssignal BS und das Referenzsignal RS, synchron sind.

Jedoch ist es notwendig, dass die Synchronisation permanent angepasst wird, da die Oszillatoren zur Signalgenerierung und Auswertung möglicherweise keine exakt identische Basisfrequenz bereitstellen. Dies erfolgt mit Hilfe sogenannter Nebenkorrelatoren um die der Hauptkorrelator jeweils um ein k x ε verschoben wird, wobei k=....-3, -2, -1, 0, 1, 2, 3....

Für die Auswertung wird ohne großen Aufwand auf abgespeicherte Werte der beiden Signale zurückgegriffen. Der Hauptkorrelator ergibt sich nach der Vorschrift $K K F \left(0\right) = \frac{1}{N} {\sum }_{i = 0}^{N - 1} \overline{X O R} \left(R S \left(i\right) , B S * \left(i\right)\right)$ wobei der Hauptkorrelator mit BS* dem um τ verschobenen ursprünglichen Begrenzungssignal entspricht. Die Nebenkorrelatoren ermitteln sich nach der Vorschrift $K K F \left(k ∗ ε\right) = \frac{1}{N} {\sum }_{i = 0}^{N - 1} \overline{X O R} \left(R S \left(i\right) , B S * \left(i - k ∗ ε\right)\right)$ wobei k=...-3, -2, -1, 0, 1, 2 , 3,... .

Um nach Ablauf einer vollen Periode sämtliche Korrelationen ausgeführt zu haben, kann es zweckmäßig sein, die einzelnen Korrelationsfunktionen gegeneinander zu verschieben (hier beispielhaft für eine Verschiebung k=-2). $K K F \left(- 2\right) = \frac{1}{N} {\sum }_{i = 0}^{N - 1} \overline{X O R} \left(R S \left(i\right) , B S \left(i + 2\right)\right) \approx \frac{1}{N} {\sum }_{i = - 2}^{N - 3} \overline{X O R} \left(R S \left(i\right) , B S \left(i + 2\right)\right)$

Durch Vergleichen der Ergebnisse aus den Korrelatoren z.B. mittels einer Maximumsuche oder einer Schwellwertbetrachtung lässt sich eine aufgetretene Zeitverschiebung detektieren und eine entsprechende Korrektur von τ durchführen. Die Korrektur kann zu festgelegten Zeitpunkten bzw. in regelmäßigen Zeitabständen durchgeführt werden.

Beim Übergang des mobilen Arbeitsgeräts von einem Inneren des Arbeitsbereiches in einen Bereich außerhalb des Arbeitsbereichs oder umgekehrt, ist es denkbar, dass bei der Korrelation Zwischenwerte auftreten bzw. die positiven bzw. negativen Korrelationsschwellenwerte nicht erreicht werden. Für diesen Fall erfolgt kann vorgesehen sein, dass keine Korrektur erfolgt. Aufgrund der hohen Abtastrate können einzelne Ausfälle toleriert werden.

Liegen über einen vorgegebenen Zeitraum (Bereich von k) keine gültigen Korrelationsergebnisse vor, d.h. die Kreuzkorrelationswerte KKF sind außerhalb der durch die Korrelationsschwellenwerte definierten Toleranzbereiche, so wird ein erneuter Durchlauf zum Finden der Korrelation zwischen dem rekonstruierten Begrenzungssignal BS und dem Referenzsignal RS, wie oben beschrieben, durchgeführt. Kann weiterhin keine Korrelation der beiden Signale festgestellt werden, so kann eine entsprechende Notfunktion ausgeführt werden, wie z.B. ein Abschalten des mobilen Arbeitsgerätes, um die Sicherheit des Gesamtsystems zu gewährleisten.

Das oben beschriebene Begrenzungssystem kann auch für den Betrieb eines halbautomatischen Arbeitsgerätes Verwendung finden. Dies kann beispielsweise ein manuell bewegter Rasenmäher sein, der z.B. das Mähwerk abschaltet, sobald die auf dem Gerät befindliche Auswerteeinheit feststellt, dass der Arbeitsbereich verlassen worden ist.

Außer zur Begrenzung von Arbeitsflächen kann mit der oben beschriebenen Anordnung zur Feststellung, ob sich das Arbeitsgerät innerhalb oder außerhalb eines Bereiches befindet, auch zur Führung des mobilen Arbeitsgerätes entlang des Begrenzungsleiter verwendet werden, z.B. das Verfolgen des Begrenzungsleiters durch das Gerät.

## Patentansprüche

1. Verfahren zum Erkennen einer Position eines Geräts (2) bezüglich eines durch ein magnetisches Wechselfeld definierten Bereichs (4), mit folgenden Schritten:
- Empfangen (S1) eines Detektionssignals, das einer durch das magnetische Wechselfeld induzierten Spannung entspricht;
- Generieren (S3) eines rekonstruierten Begrenzungssignals (BS) aus dem Detektionssignal;
- Bereitstellen (S4) eines Referenzsignals (RS), wobei das rekonstruierte Begrenzungssignal und das Referenzsignal (RS) jeweils einem Pseudozufallssignal entsprechen und wobei das Referenzsignal (RS) ein dem bereitgestellten Begrenzungssignal (BS) entsprechendes periodisches Bitmuster aufweist, wobei die Pseudo-Zufallssignale zueinander nicht synchronisiert sind;
- Durchführen (S5) eines Korrelationsverfahrens, um einen zeitlichen Korrelationsversatz zwischen dem Referenzsignal (RS) und dem rekonstruierten Begrenzungssignal (BS) und einen Korrelationswert (KKF) zwischen dem Referenzsignal (RS) und dem rekonstruierten Begrenzungssignal (BS), die um den ermittelten Versatz zueinander verschoben sind, zu ermitteln;
- Bestimmen (S7) abhängig von dem ermittelten Korrelationswert (KKF), ob sich das Gerät (2) innerhalb oder außerhalb des Bereichs (4) befindet.

2. Verfahren nach Anspruch 1, wobei das Pseudozufallssignal ein binäres Signal mit einer quasi-zufälligen Abfolge von Pegeln ist und einem periodischem Bitmuster entspricht, das so ausgewählt ist, dass eine Länge eines Abschnitts des periodischen Bitmusters, der zu einem gleich langen Abschnitt des invertierten Bitmusters identisch ist, bezüglich der gesamten Länge des Bitmusters einen vorgegebenen Anteil unterschreitet.

3. Verfahren nach einem der Ansprüche 1 bis 2, wobei das Begrenzungssignal (BS) einem Gold-Code entspricht.

4. Verfahren nach einem der Ansprüche 1 bis 3, wobei der zeitliche Korrelationsversatz zwischen dem Referenzsignal (RS) und dem rekonstruierten Begrenzungssignal (BS) ermittelt wird, indem mehrere Korrelationswerte (KKF) bei verschiedenen zeitlichen Versatzen bestimmt werden und der zeitliche Korrelationsversatz als der zeitliche Versatz bei dem betragsmäßig größten Korrelationswert (KKF) bestimmt wird.

5. Verfahren nach einem der Ansprüche 1 bis 4, wobei der Korrelationswert (KKF) mit Hilfe einer Kreuzkorrelationsfunktion, durch Addition oder Multiplikation von Abtastwerten des rekonstruierten Begrenzungssignals (BS) und von Zeitwerten des Referenzsignals (RS) bestimmt wird.

6. Gerät (2), insbesondere ein mobiles Arbeitsgerät, umfassend:
- eine Detektoreinheit (21) zum Empfangen eines Detektionssignals eines durch das Stromsignal in einem Begrenzungsleiter (3) generierten magnetischen Feldes; wobei das Stromsignal in dem Begrenzungsleiter (3) einem bereitgestellten Begrenzungssignal (BS) entspricht, das einem Pseudozufallssignal entspricht;
- einen Referenzsignalgenerator (23) zum Bereitstellen eines Referenzsignals (RS), das ein Pseudozufallssignal ist und ein dem bereitgestellten Begrenzungssignal (BS) entsprechendes periodisches Bitmuster aufweist, wobei die Pseudo-Zufallssignale zueinander nicht synchronisiert sind;
- eine Auswerteeinheit (22), die ausgebildet ist,
- um ein rekonstruiertes Begrenzungssignal (BS) aus dem Detektionssignal zu generieren,
- um ein Korrelationsverfahren durchzuführen, um einen zeitlichen Korrelationsversatz zwischen dem Referenzsignal (RS) und dem rekonstruierten Begrenzungssignal (BS) und einen Korrelationswert (KKF) zwischen dem Referenzsignal (RS) und dem rekonstruierten Begrenzungssignal (BS), die um den ermittelten Versatz zueinander verschoben sind, zu ermitteln; und
- um abhängig von dem ermittelten Korrelationswert (KKF) zu bestimmen, ob sich das Gerät (2) innerhalb oder außerhalb eines durch einen Begrenzungsleiter (3) umschlossenen Bereichs (4) befindet.

7. System zum Erkennen einer Position bezüglich eines Bereichs (4), umfassend:
- einen Begrenzungsleiter (3), der den Bereich (4) umgibt;
- ein Gerät (2) nach Anspruch 6, und
- einen Begrenzungssignalgenerator (5) zum Bereitstellen eines Stromsignals in dem Begrenzungsleiter (3) entsprechend einem bereitgestellten Begrenzungssignal (BS), wobei das Begrenzungssignal (BS) einem Pseudozufallssignal entspricht.

8. Computerprogrammprodukt, das einen Programmcode enthält, der, wenn er auf einer Datenverarbeitungseinheit ausgeführt wird, das Verfahren nach Anspruch 1 durchführt.

9. Verwendung des Systems nach Anspruch 7 in einem mobilen Arbeitsgerät, bei dem eine Bewegung des mobilen Arbeitsgeräts nur innerhalb des Bereiches (4) zugelassen wird und bei dem bei Erreichen des Begrenzungsleiters (3) eine Richtungsänderung des mobilen Arbeitsgeräts durchgeführt wird.

10. Verwendung des Systems nach Anspruch 7 in einem Überwachungsgerät, bei dem eine Funktion des Überwachungsgeräts bei Verlassen des Bereichs ausgelöst wird.

11. Verwendung des Systems nach Anspruch 7 in einem Verfolgungsgerät, bei dem das Verfolgungsgerät eine Richtungsänderung in Richtung des Begrenzungsleiters ausführt, wenn die Position des Verfolgungsgeräts als innerhalb oder außerhalb des Bereichs erkannt wird.

## Claims

1. Method for detecting a position of a device (2) with respect to an area (4) defined by an alternating magnetic field, having the following steps of:
- receiving (S1) a detection signal which corresponds to a voltage induced by the alternating magnetic field;
- generating (S3) a reconstructed boundary signal (BS) from the detection signal;
- providing (S4) a reference signal (RS), the reconstructed boundary signal and the reference signal (RS) each corresponding to a pseudo-random signal, and the reference signal (RS) having a periodic bit pattern which corresponds to the boundary signal (BS) provided, the pseudo-random signals not being synchronized with one another;
- carrying out (S5) a correlation method in order to determine a temporal correlation offset between the reference signal (RS) and the reconstructed boundary signal (BS) and in order to determine a correlation value (KKF) between the reference signal (RS) and the reconstructed boundary signal (BS) which have been shifted with respect to one another by the offset which has been determined;
- determining (S7), on the basis of the correlation value (KKF) which has been determined, whether the device (2) is located inside or outside the area (4).

2. Method according to Claim 1, the pseudo-random signal being a binary signal with a quasi-random sequence of levels and corresponding to a periodic bit pattern which is selected in such a manner that a length of a section of the periodic bit pattern, which is identical to a section of the inverted bit pattern of the same length, undershoots a predefined part of the total length of the bit pattern.

3. Method according to one of Claims 1 and 2, the boundary signal (BS) corresponding to a gold code.

4. Method according to one of Claims 1 to 3, the temporal correlation offset between the reference signal (RS) and the reconstructed boundary signal (BS) being determined by determining a plurality of correlation values (KKF) for different temporal offsets and by determining the temporal correlation offset as the temporal offset for the correlation value (KKF) of the largest magnitude.

5. Method according to one of Claims 1 to 4, the correlation value (KKF) being determined with the aid of a cross-correlation function by adding or multiplying samples of the reconstructed boundary signal (BS) and time values of the reference signal (RS).

6. Device (2), in particular a mobile working device, comprising:
- a detector unit (21) for receiving a detection signal from a magnetic field generated by the current signal in a boundary conductor (3); the current signal in the boundary conductor (3) corresponding to a boundary signal (BS) which has been provided and corresponds to a pseudo-random signal;
- a reference signal generator (23) for providing a reference signal (RS) which is a pseudo-random signal and has a periodic bit pattern corresponding to the boundary signal (BS) which has been provided, the pseudo-random signals not being synchronized with one another;
- an evaluation unit (22) which is designed
- to generate a reconstructed boundary signal (BS) from the detection signal,
- to carry out a correlation method in order to determine a temporal correlation offset between the reference signal (RS) and the reconstructed boundary signal (BS) and in order to determine a correlation value (KKF) between the reference signal (RS) and the reconstructed boundary signal (BS) which have been shifted with respect to one another by the offset which has been determined; and
- to determine, on the basis of the correlation value (KKF) which has been determined, whether the device (2) is located inside or outside an area (4) enclosed by a boundary conductor (3).

7. System for detecting a position with respect to an area (4), comprising:
- a boundary conductor (3) which surrounds the area (4);
- a device (2) according to Claim 6, and
- a boundary signal generator (5) for providing a current signal in the boundary conductor (3) according to a boundary signal (BS) which has been provided, the boundary signal (BS) corresponding to a pseudo-random signal.

8. Computer program product containing a program code which carries out the method according to Claim 1 when executed on a data processing unit.

9. Use of the system according to Claim 7 in a mobile working device, in which a movement of the mobile working device is allowed only inside the area (4) and in which the direction of the mobile working device is changed upon reaching the boundary conductor (3).

10. Use of the system according to Claim 7 in a monitoring device, in which a function of the monitoring device is triggered upon leaving the area.

11. Use of the system according to Claim 7 in a tracking device, in which the tracking device changes direction in the direction of the boundary conductor if the position of the tracking device is detected as being inside or outside the area.

## Revendications

1. Procédé d'identification d'une position d'un appareil (2) par rapport à une zone (4) définie par un champ magnétique alternatif, comportant les étapes suivantes :
- réception (S1) d'un signal de détection qui correspond à une tension induite par le champ magnétique alternatif,
- génération (S3) d'un signal de limitation (BS) reconstruit à partir du signal de détection,
- mise à disposition (S4) d'un signal de référence (RS), dans lequel le signal de limitation reconstruit et le signal de référence (RS) correspondent respectivement à un signal pseudoaléatoire et dans lequel le signal de référence (RS) comporte un motif binaire périodique correspondant au signal de limitation (BS) mis à disposition, dans lequel les signaux pseudoaléatoires ne sont pas synchronisés les uns par rapport aux autres ;
- exécution (S5) d'un traitement de corrélation pour déterminer un décalage de corrélation temporel entre le signal de référence (RS) et le signal de limitation (BS) reconstruit et pour déterminer une valeur de corrélation (KKF) entre le signal de référence (RS) et le signal de limitation (BS) reconstruit, qui sont décalés l'un par rapport à l'autre du décalage déterminé ;
- détermination (S7), en fonction de la valeur de corrélation (KKF) déterminée, du fait de savoir si l'appareil (2) se trouve à l'intérieur ou à l'extérieur de la zone (4).

2. Procédé selon la revendication 1, dans lequel le signal pseudoaléatoire est un signal binaire comportant une séquence quasi-aléatoire de niveaux et correspond à un motif binaire périodique qui est sélectionné de manière à ce qu'une longueur d'une partie du motif binaire périodique, qui est identique à une partie de même longueur du motif binaire inversé, s'abaisse en dessous d'une fraction prédéterminée par rapport à la longueur totale du motif binaire.

3. Procédé selon l'une des revendications 1 et 2, dans lequel le signal de limitation (BS) correspond à un code d'or.

4. Procédé selon l'une des revendications 1 à 3, dans lequel le décalage de corrélation temporel entre le signal de référence (RS) et le signal de limitation (BS) reconstruit est déterminé en déterminant plusieurs valeurs de corrélation (KKF) pour des décalages temporels différents et en déterminant le décalage de corrélation temporel comme étant le décalage temporel correspondant à la valeur de corrélation (KKF) la plus grande.

5. Procédé selon l'une des revendications 1 à 4, dans lequel la valeur de corrélation (KKF) est déterminée à l'aide d'une fonction de corrélation croisée par addition ou multiplication de valeurs de balayage du signal de limitation (BS) reconstruit et de valeurs temporelles du signal de référence (RS).

6. Appareil (2), notamment appareil de travail mobile, comprenant :
- une unité de détection (21) destinée à recevoir un signal de détection d'un champ magnétique généré par le signal de courant passant dans un conducteur de limitation (3) ; dans lequel le signal de courant passant dans le conducteur de limitation (3) correspond à un signal de limitation (BS) mis à disposition qui correspond à un signal pseudoaléatoire ;
- un générateur de signal de référence (23) destiné à mettre à disposition un signal de référence (RS) qui est un signal pseudoaléatoire et qui présente un motif binaire périodique correspondant au signal de limitation (BS) mis à disposition, dans lequel les signaux pseudoaléatoires ne sont pas synchronisés les uns par rapport aux autres ;
- une unité d'évaluation (22) qui est conçue pour :
- générer un signal de limitation (BS) reconstruit à partir du signal de détection,
- mettre en oeuvre un traitement de corrélation pour déterminer un décalage de corrélation temporel entre le signal de référence (RS) et le signal de limitation (BS) reconstruit et une valeur de corrélation (KKF) entre le signal de référence (RS) et le signal de limitation (BS) reconstruit, qui sont décalés l'un par rapport à l'autre du décalage déterminé ; et
- déterminer, en fonction de la valeur de corrélation (KKF) déterminée, si l'appareil (2) se trouve à l'intérieur ou à l'extérieur d'une zone (4) délimitée par un conducteur de limitation (3).

7. Système d'identification d'une position par rapport à une zone (4), comprenant :
- un conducteur de limitation (3) qui entoure la zone (4) ;
un appareil (2) selon la revendication 6, et
- un générateur de signal de limitation (5) pour la mise à disposition d'un signal de courant passant dans le conducteur de limitation (3) et correspondant à un signal de limitation (BS) mis à disposition, dans lequel le signal de limitation (BS) correspond à un signal pseudoaléatoire.

8. Produit de programme d'ordinateur comportant un code de programme qui, lorsqu'il est exécuté sur une unité de traitement de données, met en oeuvre le procédé selon la revendication 1.

9. Utilisation du système selon la revendication 7 dans un appareil de travail mobile, dans lequel un mouvement de l'appareil de travail mobile n'est autorisé qu'à l'intérieur de la zone (4) et dans lequel un changement de direction de l'appareil de travail mobile est effectué lorsque le conducteur de limitation (3) est atteint.

10. Utilisation du système selon la revendication 7 dans un appareil de surveillance, dans lequel une fonction de l'appareil de surveillance est déclenchée à la sortie de la zone.

11. Utilisation du système selon la revendication 7 dans un appareil de poursuite, dans lequel l'appareil de poursuite effectue un changement de direction dans la direction du conducteur de limitation lorsque la position de l'appareil de poursuite est identifiée comme étant à l'intérieur ou à l'extérieur de la zone.
